# EUROPEAN PATENT APPLICATION

(11) **EP 4 739 049 A1**
(43) Date of publication of application: **06.05.2026**
(21) Application number: 24210464.4
(22) Date of filing: 04.11.2024
(51) Int. Cl.: H10K 30/85, H10K 71/40, H10F 77/12, H10F 77/20

(54) **SEMITRANSPARENT THIN FILM SOLAR CELL AND PREPARATION METHOD THEREOF**

(71) Applicant: Tallinn University of Technology, 19086 Tallinn (EE)
(72) Inventor: Krunks, Malle, 19086 Tallinn (EE); Spalatu, Nicolae, 19086 Tallinn (EE); Katerski, Atanas, 19086 Tallinn (EE); Asare, Ernest, 19086 Tallinn (EE); Saleh, Hadeer, 19086 Tallinn (EE); Oja Acik, Ilona, 19086 Tallinn (EE)
(74) Representative: Moosedog Oy

(57) **Abstract**

Disclosed is a customized semitransparent thin film solar cell comprising a substrate layer comprising a transparent conductive oxide on top of a glass layer, a double electron transport layer comprising a first electron transport layer and a second electron transport layer deposited by ultrasonic spray pyrolysis (USP), an absorber layer deposited by USP, and a back contact layer.

## Description

### TECHNICAL FIELD

The present disclosure relates to semitransparent thin film solar cells. It further covers methods for preparing semitransparent thin film solar cells, ensuring both transparency and efficiency.

### BACKGROUND

Significant progress has been achieved in the development of various solar cell technologies, including silicon solar cells, organic solar cells, dye sensitized solar cells, Quantum dots solar cells, perovskite solar cells and chalcogenide solar cells. Furthermore, there is a need for semitransparent solar cells, offering the dual benefits of energy generation and transparency, which makes them suitable for integration.

Semitransparent solar cells, while promising for applications like building-integrated photovoltaics and transparent displays, face several significant drawbacks. Traditional solar cells, such as crystalline silicon-based cells, are designed to maximize light absorption to convert sunlight into electrical energy efficiently and therefore these cells are opaque and cannot be used in applications requiring transparency. Additionally, many semitransparent technologies, such as organic photovoltaics and perovskites, suffer from limited durability and stability, particularly when exposed to environmental factors like UV radiation and moisture. Moreover, achieving high transparency often results in unwanted color tints, which can be aesthetically undesirable for certain applications. Lastly, the manufacturing processes for semitransparent cells tend to be more complex and expensive, making large-scale production economically challenging.

Typical semitransparent solar cell has the following structure: substrate/transparent conductive oxide/electron transport layer/absorber layer/hole transport layer/back contact. Out of these layers, electron transport layer (ETL) presents several challenges that need to be addressed for optimal performance. One of the key issues is the trade-off between transparency and conductivity, as many ETL materials that offer good electron transport properties tend to be opaque, which can compromise the transparency of the solar cell. Additionally, poor energy level alignment between the ETL and the active layer can lead to inefficient charge extraction and increased recombination, reducing overall efficiency. Surface defects and trap states in the ETL can further hinder electron mobility and lead to performance degradation over time. Finally, achieving an optimal thickness for the ETL is crucial-too thin can result in poor charge transport, while too thick can introduce optical losses and increase resistance. Addressing these issues is essential for improving the efficiency, stability, and transparency of semitransparent solar cells.

In addition, for preparation of absorber layer, most widely employed techniques for the deposition of an absorber layer are spin-coating, hydrothermal growth and chemical bath deposition. The highest efficiencies are obtained by these techniques, comprising absorber with thickness approximately higher than 250 nm. However, such absorber thickness compromise the development of semi-transparency concept.

Therefore, in light of the foregoing discussion, there exists a need to overcome the aforementioned drawbacks associated with making semitransparent solar cells.

### SUMMARY

The aim of the present disclosure is to provide a semitransparent thin film solar cell which has a customizable semitransparency and a method to produce thin film solar cell capable of enhanced power conversion efficiency under low light illumination conditions and compatible with powering IoT eco-systems. The aim of the disclosure is achieved by a system for producing a semitransparent thin film solar cell, as defined in the appended independent claims to which reference is made to.

Additional aspects, advantages, features, and objects of the present disclosure would be made apparent from the drawings and the detailed description of the illustrative embodiments constructed in conjunction with the appended claims that follow.

Throughout the description and claims of this specification, the words *"comprise", "include", "have",* and *"contain"* and variations of these words, for example *"comprising"* and *"comprises",* mean *"including but not limited to",* and do not exclude other components, items, integers or steps not explicitly disclosed also to be present. Moreover, the singular encompasses the plural unless the context otherwise requires. In particular, where the indefinite article is used, the specification is to be understood as contemplating plurality as well as singularity, unless the context requires otherwise.

### BRIEF DESCRIPTION OF THE DRAWINGS

The summary above, as well as the following detailed description of illustrative embodiments, is better understood when read in conjunction with the appended drawings. For the purpose of illustrating the present disclosure, exemplary constructions of the disclosure are shown in the drawings. However, the present disclosure is not limited to specific instrumentalities disclosed herein. Moreover, those skilled in the art will understand that the drawings are not to scale. Wherever possible, similar elements have been indicated by identical numbers.
FIG. 1A and 1B are a schematic illustration of the semitransparent thin film solar cells with customizable semitransparency.
FIG. 2A and FIG. 2B illustrate semitransparent thin film solar cell performance under standard 1.5AM and indoor conditions.
FIG. 3A and FIG. 3B illustrate XRD patterns of crystalline Sb₂S₃ absorber layer texture coefficient of dominate diffraction peaks of the Sb₂S₃ films, respectively.
FIG. 4 illustrates a cross-section SEM image of the semitransparent thin-layer solar cell.
FIG. 5A and FIG. 5B present a total transmittance spectra and average visible transmittance of the semitransparent thin film solar cell, respectively.
FIG. 6 illustrates XRF analysis results for thicknesses of the absorber layer.
FIG. 7 illustrates output parameters of the semitransparent thin film solar cell depending on the ZnO layer thickness controlled via spray cycles for ZnO.
FIG. 8 illustrates current voltage curves of the semitransparent thin film solar cells.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practicing the present disclosure are also possible.

In a first aspect, the present disclosure provides a semitransparent thin film solar cell comprising following stacked layers:
- a substrate layer comprising a transparent conductive oxide, TCO, on top of a glass layer;
- a double electron transport layer, ETL, comprising
   - a first electron transport layer, ETL1, and
   - a second electron transport layer, ETL2, deposited by ultrasonic spray pyrolysis, USP;
- an absorber layer deposited by ultrasonic spray pyrolysis, USP;
- a back contact layer.

In a second aspect, the present disclosure provides a method of preparing semitransparent thin film solar cell, the method comprising:
- cutting a glass substrate comprising a transparent conductive oxide layer, TCO, on top of a glass;
- cleaning the substrate layer;
- producing a double electron transport layer, ETL, on top of the substrate TCO layer by
- depositing a first electron transport layer, ETL1, and
- depositing a second electron transport layer, ETL2, by ultrasonic spray pyrolysis, USP;
- depositing an absorber layer by ultrasonic spray pyrolysis, USP;
- annealing the cleaned substrate layer, the double electron transport layer and the absorber layer at a temperature range from 260 °C up to 310 °C in nitrogen flow for at least 2 minutes up to 20 minutes;
- adding a back contact layer.

In regard to the first aspect of the present invention, it discloses a semitransparent thin film solar cell structure with the following layers: a substrate layer, a double electron transport layer, an absorber layer and a back contact layer. Herein, the term "substrate layer" refers to a foundational material on which the layers of the semitransparent thin film solar cell are stacked to. Unless otherwise specified, any reference to the term "solar cell" in this document should be interpreted to include semitransparent thin-film solar cells with customizable semitransparency. The main purpose of the substrate layer in the solar cell is to provide structural support, ensuring the integrity and durability of the entire device. Herein, it acts as a stable platform for the deposition of solar cell layers while also contributing to thermal management by dissipating heat generated during operation. The technical effect of using the substrate layer that comprises a transparent conducting oxide, TCO, on top of glass is that TCOs are transparent to visible light while also being electrically conductive, allowing light to pass through. Since TCO is transparent, it maximizes the amount of light that can enter the solar cell, which is particularly beneficial in applications like semitransparent thin film solar cells, where light needs to penetrate through both sides of the cell. Glass provides a rigid and durable foundation, offering mechanical stability to the overall solar cell structure. Furthermore, glass serves as an excellent barrier against moisture, oxygen, and UV radiation, helping to protect the internal components of the solar cell, while also managing heat dissipation. The smooth surface of glass provides an ideal platform for uniform deposition of the TCO and other subsequent layers, ensuring high-quality interfaces and better device performance.

Herein, the term "double electron transport layer" refers to a transport layer that is made out of two different electron transport layers stacked together, instead of a single layer, to improve charge separation at the main interface and device performance. Each of the two ETL layers typically has different material properties that complement one another, optimizing various aspects of the solar cell's function. The combination of the two electron transport layers improves the structural quality of the absorber layer near interface with the second electron transport layer. In addition, this evolvement of the second electron transport layer improves the selectivity of charge carrier in the first electron transport layer. Furthermore, by using a double ETL, the second electron transport layer acts as a protective barrier, improving the solar cell's stability and longevity.

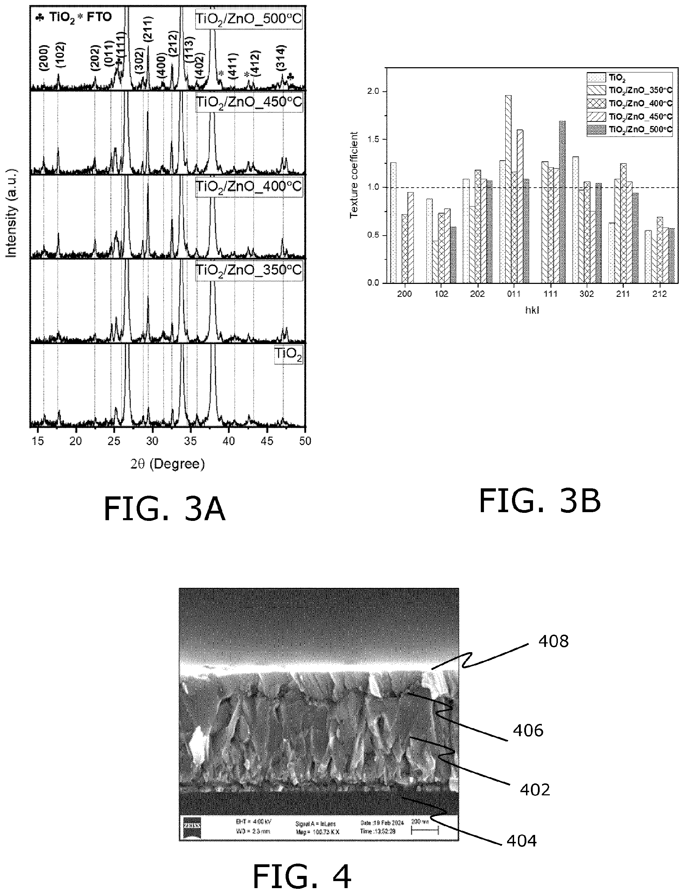

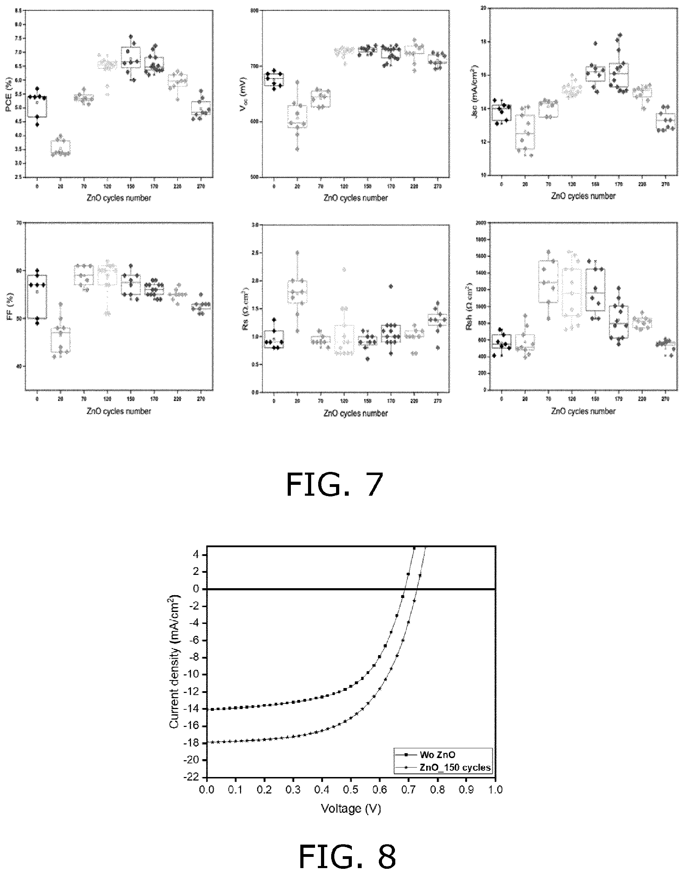

The technical effect of the double electron transport layer in the semitransparent thin film solar cell with a customizable semitransparency is that the leakage current of the semitransparent thin film solar cell is reduced, which means increased solar cell output characteristics such as increased Voc, Jsc, FF, Rsh, see FIG. 7 and FIG. 8. Additionally, better vertical alignment of crystallites in the absorber layer is obtained, including crystallite orientation in (hk1) direction (knowing to be favorable for efficient charge transport), see FIG. 3B.

Herein, the terms "first electron transport layer" and "second electron transport layer" refer to the two electron transport layers that the double electron transport layer is made of. The first electron transport layer is between the substrate with TCO layer and the second electron transport layer. The second electron transport layer is deposited by ultrasonic spray pyrolysis.

Herein, the term "absorber layer" refers to the layer responsible for capturing sunlight and converting it into electrical energy. The absorber layer is deposited by ultrasonic spray pyrolysis. The deposition of the absorber layer is a crucial part of preparing the absorber layer with effective properties.

The technical effect of the semitransparent thin film solar cell presented in the first aspect is the enhancement of light transmission and electron transport efficiency while maintaining high device stability and performance. The use of a transparent conductive oxide (TCO) on a glass substrate allows for efficient light transmission, while the double electron transport layer (ETL) optimizes electron extraction and minimizes recombination losses. The deposition of the first electron transport layer and the absorber layer by the ultrasonic spray pyrolysis (USP) ensures uniform thin films with controlled thickness, improving the interface quality between layers. This combination enhances overall energy conversion efficiency, stability, and transparency, making the solar cell suitable for applications like powering IoT eco-systems under low light environments and building-integrated photovoltaics (BIPV) where both transparency and power generation are required.

Optionally, the first electron transport layer and the second electron transport layer can be prepared by atom layer deposition (ALD), spin-coating, sputtering, SILAR (successive ionic layer absorption and reaction).

Optionally, the semitransparent thin film solar further comprises a hole transport layer, HTL, between the absorber layer and the back contact layer. Technical effect of using HTL in the solar cell is to facilitate the efficient extraction and transport of positive charge carriers (holes) from the absorber layer to the back contact layer, while simultaneously blocking the flow of electrons to the back contact layer, thus minimizing recombination losses. By improving hole mobility and preventing electrons from reaching the wrong electrode, the HTL enhances the overall charge separation and collection efficiency, leading to increased power conversion efficiency.

Optionally, the absorber layer thickness is from 40 nm up to 200 nm. Optionally, the absorber layer thickness is from 40, 90, 110, 130, 150, 170, 190 nm up to 80, 100, 120, 140, 160, 180, 200 nm. Technical effect of the customized semitransparent thin film solar cell with a thickness in the range of 40 nm to 200 nm is a balance between transparency and efficiency. This thickness range permits more light to pass through the cell, making it semitransparent and suitable for applications like powering IoT eco-systems under low light environments and building-integrated photovoltaics (BIPV), windows, or displays, where transparency is important. The abovementioned range can still absorb enough sunlight to generate a reasonable amount of electricity ensuring that the solar cell remains functional while being partially transparent.

Optionally, at least one of the first electron transport layer, ETL1, and the second electron transport layer, ETL2, comprises at least one of selected materials from: TiO₂, ZnO, SnO₂, ZnS, Zn(O,S), Sb-doped ZnO. All of the listed materials are wide-bandgap semiconductors with high electron mobility and therefore suitable for electron transport layers in solar cells. Technical effect of these materials is that they have high electron mobility, which allows for efficient extraction and transport of charge carriers to respective front and back contact layers, minimizing recombination losses. They possess suitable conduction band positions that align well with the absorber materials, facilitating effective charge extraction. Beneficially, these compounds are transparent in the visible spectrum, allowing light to pass through them, which is particularly important for applications like semitransparent solar cells and enhancing light absorption in the active layer. These materials are generally stable under environmental conditions such as UV exposure, high temperatures, and moisture, contributing to the long-term durability of solar cells. Their wide bandgaps help them act as electron-selective layers, efficiently blocking accumulation of holes (positive charge carriers) at the front contact and preventing recombination, which is crucial for improving the overall efficiency of the solar cell. Owing to it unique properties of the above mentioned materials, they play a pivotal role in achieving effective heterojunction interface management, which crucial for enhancing the overall efficiency.

When absorber layer is Sb₂S₃, then incorporation of ZnO onto the first electron transport layer allows effective control over Sb₂S₃ crystal orientation along the preferred (hk1) direction in the absorber layer and can significantly increase the grain size and growth. Additionally, ZnO on the first electron transport layer can passivate the defects present in TiO₂ surface. These the features of the present disclosure significantly enhance optoelectronic properties led to significant enhancement in the solar cell performance.

Optionally, the absorber layer comprises at least one of selected materials from: Sb₂S₃, AgBiS₂, AgSbS₂, CuSbS₂, CuBiS₂, Bi₂S₃, Sb₂(S,Se)₃, Sb₂Se₃. All of the listed materials are emerging chalcogenide-based semiconductors (compounds containing sulfur, selenium), which offer several common features that make them suitable as absorber layer materials in solar cells. Technical effect of these materials is that typically they exhibit strong absorption of light in the visible range, making them effective at capturing sunlight even with thin layers. This is essential for maximizing the power conversion efficiency of the solar cells. Advantage is also that these materials are composed of relatively non-toxic and earth-abundant elements (e.g., antimony, bismuth, sulfur, selenium), making them environmentally friendly and more cost-effective for large-scale production. These chalcogenide-based semiconductors have bandgaps in the range of 1.1-1.8 eV, which is ideal for absorbing a significant portion of the solar spectrum and efficiently converting light into electricity. These materials can often be processed at relatively low temperatures, which simplifies manufacturing and allows compatibility with flexible substrates and large-scale production techniques. Therefore, the technical effect lies in their strong light absorption, tunable bandgap, environmental friendliness, low environmental impact and chemical stability, making them good candidates for use as absorber layers in customized semitransparent thin film solar cells. All these emerging chalcogenides listed above have quasi 1D crystal structure.

Optionally, the hole transport layer, HTL, comprises at least one of selected from: P3HT, NiOx, Spiro-OmeTAD, MnS, MoOs, small organic molecules. P3HT (poly(3-hexylthiophene)), NiOx (nickel oxide), Spiro-OMeTAD, MnS (manganese sulfide), MoO₃ (molybdenum trioxide), and small organic molecules exhibit high hole mobility and charge selectivity, making them effective at transporting holes (positive charge carriers) while blocking electrons at the back contact of the solar cells. Technical effect is that this selective transport reduces charge recombination at the interface between the absorber and the back contact layer, improving power conversion efficiency. These HTL materials are chosen based on their suitable energy level alignment, which matches well with the valence band of the absorber layer, enabling efficient charge extraction. Some of these HTLs, especially metal oxides like MnS, Spiro-OMeTAD, NiOx and MoO₃, are transparent to visible light, making them suitable for use in semitransparent and bifacial solar cells, where light must pass through the HTL.

Optionally, the back contact layer comprises at least one of selected from: Au, Ag, Ag nanowires, C. The back contact layers made from Au (gold), Ag (silver), Ag nanowires, and C (carbon) in solar cells have an advantage that they have high electrical conductivity, which enables efficient charge collection and transport. These materials are commonly used for their ability to facilitate the movement of electrons from the solar cell to the external circuit with minimal resistive losses. All of these materials have excellent conductivity, which allows them to effectively collect and transport electrons from the absorber layer to the external circuit, minimizing resistance and maximizing the cell's power output. Metals like Au and Ag are highly reflective, which can help reflect unabsorbed light back into the absorber layer, improving light absorption and overall solar cell efficiency. This is particularly beneficial in thin film solar cells. Au, Ag, and carbon are chemically stable, resistant to corrosion and oxidation, ensuring long-term durability and reliable performance as a back contact. Ag nanowires, in particular, can provide flexibility and transparency, making them suitable for flexible or transparent devices. Carbon, especially in forms like graphene or carbon nanotubes, is abundant, low-cost, and scalable for large-area applications, while Ag nanowires offer a balance between performance and material savings compared to bulk silver or gold.

A method of preparing semitransparent thin film solar cell, the method comprising:
- cutting a glass substrate comprising a transparent conductive oxide layer, TCO, on top of a glass;
- cleaning the substrate layer;
- producing a double electron transport layer, ETL, on top of the substrate TCO layer by
- depositing a first electron transport layer, ETL1, and
- depositing a second electron transport layer, ETL2, by ultrasonic spray pyrolysis, USP;
- depositing an absorber layer by ultrasonic spray pyrolysis, USP;
- annealing the cleaned substrate layer, the double electron transport layer and the absorber layer at a temperature range from 260 °C up to 310 °C in nitrogen flow for at least 2 minutes up to 20 minutes;
- adding a back contact layer.

In regard to the second aspect of the present invention, it discloses a method of preparing semitransparent thin film solar cell. The method comprises of the steps to stack up all the necessary layers of the semitransparent thin film solar cell, including the substrate layer, the double electron layer, the absorber layer and the back contact layer. For the second electron layer and the absorber layer, ultrasonic spray pyrolysis is used.

Usually, most widely employed techniques for the deposition of the absorber layer are spin-coating, hydrothermal growth and chemical bath deposition. The highest efficiencies are obtained by these techniques. Related to spin-coating the major drawback is ununiformity in thickness. Related to hydrothermal growth, spin-coating and chemical bath deposition the major drawbacks are use of inert atmosphere which implies glovebox or sophisticated set-ups impending transferability of processes at large scaleup. However, technical effect of using an ultrasonic spray pyrolysis, USP for depositing the second electron transport layer and the absorber layer is that it allows the deposition at low processing temperatures in air atmospheres and there is no need for glove box or vacuum technologies. The deposited layers are uniform and suitable for effective solar cells. USP technique is a powerful, solution-based chemical deposition method that provides rapid, scalable, and cost-effective deposition. Furthermore, resource saving approach combining low initial material amounts and low waste generation.

The cleaned substrate layer, the double electron transport layer and the absorber layer are annealed at a temperature range from 260, 270, 280, 290, 300 °C up to 270, 290, 300, 310 °C in nitrogen flow for at least 2, 5, 10, 15 minutes up to 5, 7, 15, 20 minutes. Beneficially, annealing in nitrogen flow improves absorber layer quality, enhances crystallinity of the absorber layer, and prevents oxidation, which collectively contribute to better solar cell performance and long-term stability. The use of nitrogen ensures that the annealing process occurs without unwanted chemical reactions.

The disclosed method for preparing semitransparent thin film solar cell with customizable semitransparency produces effective thin film solar cell compatible with devices operating under both 1.5AM and low light conditions.

Optionally, depositing the absorber layer by ultrasonic spray pyrolysis, USP, is carried out with following conditions:
- at a temperature range from 170 °C up to 210 °C for at least 20 minutes up to 120 minutes,
- depositing a precursor solution at a rate ranging from 2.0 ml/min up to 4.8 ml/min with a carrier gas at a rate ranging from 2 L/min up to of 5 L/min and director gas from 0.2 L/min to 1 L/min to form Sb₂S₃, L/min wherein the precursor solution comprises an antimony chloride (SbCl₃) and a thiourea (SCN₂H₄, tu) with a molar ratio ranging from 1:2.5 up to 1:9 dissolved in methanol, and wherein the antimony chloride concentration is ranging from 15 mM up to 65 mM.

The technical effects of using USP under the specified conditions for contribute to the formation of a high-quality, uniform Sb₂S₃ absorber layer with improved crystallinity, and thickness control, which enhances the performance of solar cells. The temperature range from 170, 180, 190, 200 °C up to 180, 190, 200, 210 °C, combined with a deposition time from 20, 40, 60, 80, 100 min up to 30, 50, 70, 90, 120 minutes, ensures that the precursor materials decompose efficiently and uniformly to form a Sb₂S₃ film. This controlled temperature within the depositing an absorber layer allows for optimal crystallization of Sb₂S₃, enhancing its optical and electronic properties, which are critical for its performance as an absorber layer in solar cells. Heating within this temperature range promotes better crystal growth and reduces defects in the deposited Sb₂S₃. Higher crystallinity leads to improved charge carrier mobility and reduced recombination losses, which enhances the solar cell's efficiency. For the abovementioned technical effects the most optimal temperature depositing an absorber layer by ultrasonic spray pyrolysis is 185 °C and the time 40 min.

The precursor solution deposition rate range from 2.0, 3.0 and 4.0 ml/min up to 2.5, 3.5 and 4.8 ml/min and the carrier gas flow rate range from 2, 3 and 4 L/min to 3, 4 and 5 L/min ensure consistent and uniform deposition of Sb₂S₃ across the substrate. For the uniform thickness of the absorber layer, the precursor solution should be deposited at 2.4 ml/min and the carrier gas flow rate should be 3 L/min and director gas should be 0.5 L/min.

The molar ratio of antimony chloride to thiourea in the range of 1:2.5, 1:3, 1:4, 1:5, 1:6, 1:7, 1:8 up to 1:3.5, 1:4.5, 1:5.5, 1:6.5, 1:7.5, 1:8.5 and to 1:9 ensures the formation of pure phase of Sb₂S₃. These ratios help avoid the formation of secondary phases or defects, resulting in a pure, high-quality Sb₂S₃ absorber layer. The most optimal range for the molar ratio of antimony chloride to thiourea is 1:3 up to 1:6. The concentration of antimony chloride in the range of 15, 30, 45 and 60 mM up to 20, 35, 50 and 65 mM in the precursor solution allows for the adjustment of absorber film thickness. This flexibility in controlling absorber film thickness is crucial for optimizing the solar cell's efficiency and light absorption. Therefore, the most optimal concentration of antimony chloride in the precursor solution is 60 mM. Beneficially, USP, with these parameters, provides a scalable and cost-effective method for fabricating Sb₂S₃ films, suitable for large-scale production. The use of methanol as a solvent ensures efficient dissolution of precursors and fast evaporation during deposition, leading to high-quality film formation.

Optionally, preparing semitransparent thin film solar cell, the method comprising:
- depositing the first electron transport layer, ETL1, comprises depositing titanium(IV)isoproxide and acetylacetone on the transparent conductive glass layer to form the first electron transport layer, wherein a molar ratio of titanium(IV)isoproxide and acetylacetone is ranging from 1:1 to 1:4 and temperature used during ultrasonic spray pyrolysis is ranging from 300 °C up to 500 °C;
- annealing the first electron transport layer at temperature range from 400 °C up to 500 °C for at least 30 minutes up to 120 minutes, and
- depositing the second electron transport layer, ETL2, comprises spraying a solution onto the first electron transport layer at temperature of 400 °C up to 500 °C to form a second electron transparent layer, wherein the solution comprises Zn(CH₃CO₂)₂ in deionized water and isopropyl alcohol mixture (2:3 by volume) with a Zn(CH₃CO₂)₂ concentration range from 1·10⁻⁴ mol/L up to 9·10⁻⁴ mol/L.

The technical effect of preparing semitransparent thin-film solar cell electron transport layers using the above described method is the creation of high-performance, optimized double electron transport layer, ETL, that improves charge transport, device stability, and overall efficiency. The deposition of the first electron transport layer, ETL1, using titanium(IV)isopropoxide and acetylacetone ensures good electron mobility and charge extraction. The molar ratio of 1:1, 1:2 and 1:3 up to 1:2, 1:3 and 1:4 of titanium(IV) isopropoxide to acetylacetone is tuned to control the layer's thickness and crystallinity, allowing for efficient electron transport with minimal recombination losses. The most efficient electron transport is achieved with a molar ratio of 1:1. Heating this layer at high temperatures further enhances crystallinity, improving electron conductivity. The use of ultrasonic spray pyrolysis (USP) at a temperature range of 300, 350, 400, 450 °C up to 340, 375, 425 and 500 °C ensures uniform deposition of ETL1 on the transparent conductive glass substrate. The uniformity of the ETL1 is most optional when the USP is carried out at 340 °C.

The high temperatures used during deposition and additionally using a post-deposition annealing at 400 °C-500 °C for the first electron transparent layer allow for better adhesion of the titanium(IV)isoproxide and densification of the first electron transport layer. Annealing the first electron transport layer should last in the range of 30, 60, 90 and 110 min up to 45, 75, 105 and 120 min. The most optimal conditions for annealing the first electron transport layer is at 450 °C for 30 min.

The second electron transport layer is deposited at temperatures in a range from 400 °C-500 °C. Optionally, a few drops of acetic acid can be added to the solution to avoid precipitation of zinc hydroxide. Zn(CH₃CO₂)₂ concentration is in the range from 1·10⁻⁴, 3·10⁻⁴, 5·10⁻⁴ and 7·10⁻⁴ mol/L up to 2·10⁻⁴, 4·10⁻⁴, 6·10⁻⁴ and 9·10⁻⁴ mol/L. The most optimal conditions for depositing the second electron transport layer is at temperature is 400 °C and with Zn(CH₃CO₂)₂ concentration of 5·10⁻⁴ mol/L.

The second electron transport layer, ETL2, made from Zn(CH₃CO₂)₂, improves energy level alignment between ETL2 and the absorber layer. This combination of materials (TiO₂ for ETL1 and ZnO for ETL2) ensures efficient electron extraction at the front contact, facilitating smooth charge transfer across the layers.

Optionally, alternatively, depositing the second electron transport layer, ETL2, comprising spraying a second solution onto the first electron transport layer, wherein the second solution contains 1:2 molar ratio of ZnCl₂ and thiourea (SCN₂H₄, tu) , with ZnCl₂ concentration set at 5·10⁻⁴M in ethanol. The deposition is carried out by using USP method, typically, 70 cycles of the second solution was sprayed at surface temperatures (Ts) ranging from 350 °C to 500 °C in air.

By using the double electron transport layer, the method minimizes charge recombination at the interface between the absorber and the double electron transport layer.

The careful selection of deposition parameters and materials (TiO₂ and ZnO) ensures that the first electron transport layer and the second electron transport layer are transparent, allowing light to pass through the solar cell while still performing efficient electron transport. This is crucial for semitransparent applications, such as building-integrated photovoltaics (BIPV), where both transparency and energy generation are required. Furthermore, these semitransparent solar cells are suitable in low light illumination conditions compatible with powering IoT eco-systems.

Optionally, method further comprises producing a hole transport layer, HTL, between the absorber layer and the back contact layer, wherein the hole transport layer is produced as Poly(3-hexylthiophene-2,5-diyl), P3HT, Spiro-OmeTAD, small organic molecules, MoOs layer, NiOx layer, MnS layer or NiOx nanoparticle layer. The technical effect of preparing a semitransparent thin film solar cell hole transport layer, HTL, using materials such as Poly(3-hexylthiophene-2,5-diyl) (P3HT), Sprio-OmeTAD, small organic molecules, MoOs, NiOx, MnS, or NiOx nanoparticles between the absorber layer and the back contact layer is the enhancement of hole transport and charge separation, reduction of recombination losses, maintenance of semitransparency, and efficiency, particularly for semitransparent thin-film solar cells. Each of these materials (P3HT, Sprio-OmeTAD, small organic molecules, MoOs, NiOx, MnS, NiOx nanoparticles) reduces the recombination at back contact allowing for efficient extraction and transport of positive charge carriers (holes) from the absorber layer to the back contact, leading to increased power conversion efficiency in the solar cell. These HTL materials act as hole-selective layers, allowing holes to pass through while blocking electrons. This prevents charge recombination at the interface between the absorber and the back contact layer, improving charge separation and overall device performance.

The HTL forms an improved interface with both the absorber layer and the back contact layer, reducing interface defects and lowering the chances of charge recombination. This improves the overall efficiency of the solar cell. Materials like Sprio-OmeTAD, MoOs, NiOx, and MnS have wide bandgaps and thus optically transparent, which allows light to pass through the HTL layer without significant absorption losses. This is particularly important in the customized semitransparent thin film solar cells, as it ensures that the device maintains both transparency and photovoltaic efficiency, making them suitable for applications such as building-integrated photovoltaics (BIPV).

Inorganic materials such as MoOs, NiOx, and MnS provide high chemical and thermal stability, which helps in increasing the operational lifetime of the solar cell, especially under environmental stress such as UV exposure, humidity, and temperature fluctuations. These stable materials ensure that the HTL layer retains its functionality over time, improving the long-term reliability of the device. These HTL materials can be deposited through various scalable methods, including solution processing (NiOx), thermal evaporation (MoOs, NiOx), or chemical deposition (MnS). This flexibility in processing allows for their integration into different thin-film solar cell designs and manufacturing processes.

Optionally, producing the Poly(3-hexylthiophene-2,5-diyl), P3HT, layer comprises following steps:
- spin coating a Poly(3-hexylthiophene-2,5-diyl), P3HT, onto the absorber layer at speed of 3000 rpm for 0.33 minutes to form thin film layers, wherein the Poly(3-hexylthiophene-2,5-diyl) is dissolved in chlorobenzene with concentration of 1 wt%,
- heating the formed thin film layers in an inert atmosphere at 150 °C for 5 min.

The technical effects of this process are the formation of a uniform, thin P3HT layer with improved hole mobility and transport, enhanced transparency, and increased stability, all of which contribute to the efficient functioning of a semitransparent thin-film solar cell. The spin coating process at 3000 rpm for 20 seconds ensures the formation of a thin and uniform P3HT layer on the absorber layer. This precise control over the film thickness is critical for achieving consistent hole transport and minimizing any defects or variations that could lead to performance loss or charge recombination. Dissolving P3HT in chlorobenzene at 1 wt% provides an optimal solution concentration for forming a thin, semitransparent layer allowing for transparency while still efficiently transporting holes. This is especially important in semitransparent solar cells, where both light transmission and power generation are required.

The P3HT layer acts as a hole transport layer, HTL, and by forming a thin, defect-free film, it ensures efficient extraction and transport of holes from the absorber layer to the back contact layer. This reduces charge recombination and improves the overall efficiency of the solar cell.

Heating the formed thin film in an inert atmosphere at 150 °C for 5 minutes allows for improved crystallinity of the P3HT, enhancing its electrical properties. The annealing process helps align polymer chains, which increases the hole mobility and enhances charge transport, leading to better overall device performance. The heating step in an inert atmosphere (such as nitrogen or argon) evaporates solvent.

Optionally, adding the back contact layer is carried out by depositing at least one of: Au, Ag; and wherein depositing is carried out using vacuum evaporation technique or Ag nanowire.

The technical effect of adding a back contact layer using Au, Ag, or Ag nanowires, with vacuum evaporation or Ag nanowire deposition techniques, is improved electrical conductivity, enhanced light management, maintained semitransparency, good interface quality, and long-term stability, all contributing to the overall efficiency and reliability of the semitransparent thin film solar cell. The use of Au or Ag provides excellent electrical conductivity, ensuring efficient carrier collection and transport from the solar cell to the external circuit. This minimizes resistive losses and enhances the power conversion efficiency of the solar cell. Both Ag nanowires and thin layers of Au or Ag deposited by vacuum evaporation can be made sufficiently thin to maintain the semitransparency of the solar cell. This is crucial for applications like building-integrated photovoltaics (BIPV), where both transparency and power generation are important. Ag nanowires, in particular, offer a transparent conductive network that allows light to pass through while still providing efficient charge collection.

Thin metallic back contacts like Au or Ag can also act as reflective layers. This can increase the optical path length of light within the absorber layer, enhancing light absorption and improving the overall efficiency of the device, particularly in thin-film solar cells. The use of vacuum evaporation ensures a smooth and uniform deposition of the back contact layer, providing excellent adhesion to the underlying layers. This minimizes the formation of interface defects, reducing charge recombination at the back contact and further improving efficiency.

Using Ag nanowires offers flexibility and compatibility with low-temperature processing methods, making the back contact suitable for flexible or lightweight solar cells. Ag nanowires can also be integrated into roll-to-roll production, enabling scalable fabrication for large-area solar cells.

Optionally, depositing the absorber layer comprising Sb₂S₃ by ultrasonic spray pyrolysis, USP, is carried out:
- at a nebulization frequency of ranging from 1 MHz up to 2 MHz, and
- with a power of ranging from 30 W up to 300 W.

The technical effect of depositing the Sb₂S₃ absorber layer using ultrasonic spray pyrolysis at the specified frequency and power ranges is the formation of a high-quality, uniform, and efficient absorber layer with optimized thickness, and morphology, contributing to improved performance, scalability, and transparency in customized semitransparent thin-film solar cells. The high nebulization frequency (1 MHz to 2 MHz) results in fine atomization of the precursor solution, producing smaller droplets. This leads to uniform and controlled deposition of the Sb₂S₃ absorber layer, which ensures smooth film formation with fewer defects, reducing charge carrier recombination and improving the overall efficiency of the solar cell. The specified power range (30 W to 300 W) allows control over the deposition rate. Higher power levels can lead to faster deposition and thicker films, while lower power levels result in thinner layers. By tuning the power, the absorber layer's thickness can be optimized for light absorption, contributing to enhanced photon capture and better charge generation, while also ensuring transparency for semitransparent solar cell applications. Controlling the growth process of Sb₂S₃ crystals plays a crucial role in improving semitransparent thin film solar cell quality and performance.

The high-frequency ultrasonic spray pyrolysis process, ensures the fine droplet size and controlled deposition conditions ensure that the absorber layer has a uniform morphology with reduced roughness. This leads to better interface quality with adjacent layers (such as the electron transport layer or the hole transport layer), improving charge extraction and reducing interfacial recombination losses.

USP is a scalable, low-cost deposition technique that can be easily applied to large-area solar cells. The ability to fine-tune the deposition parameters, such as frequency and power, makes it suitable for industrial-scale production of Sb₂S₃-based thin film solar cells, with consistent quality and performance. By optimizing the deposition rate and uniformity, the Sb₂S₃ absorber layer can be thin enough to maintain the semitransparency of the solar cell while still providing sufficient light absorption for energy generation. This is particularly beneficial for applications like building-integrated photovoltaics (BIPV) and customized product integrated photovoltaics (PIPV), where both transparency and efficiency are important.

Optionally, spraying is carried at least 30 minutes up to 90 minutes at spraying rate ranging from 2 ml/min up to 5 ml/min using a carrier gas with the carrier gas rate ranging from 3 L/min up to 10 L/min and a director gas with the director gas rate ranging from 0.2 L/min up to 1 L/min.

The technical effect of spraying with these specific conditions is the formation of a high-quality, uniform, and smooth thin film with controlled thickness, all contributing to enhanced solar cell efficiency, and cost-effectiveness, especially for thin-film or semitransparent solar cell applications. The spraying rate (3 ml/min to 5 ml/min) ensures a controlled deposition of the material over time, allowing for precise control of the thickness of the layer. This extended spraying duration (30 to 90 minutes) allows for the gradual build-up of a uniform, consistent layer. Achieving the right thickness is critical for optimizing the solar cell's light absorption and charge transport properties, especially for thin-film and semitransparent applications. The carrier gas rate (3 L/min to 10 L/min), combined with the director gas rate (0.2 L/min to 1 L/min), controls the dispersion and direction of the spray, leading to fine atomization and a consistent droplet size. This ensures smooth, even distribution of the material across the substrate, minimizing defects, pinholes, and roughness. A defect-free film enhances charge carrier mobility and reduces recombination losses, improving overall efficiency.

A controlled and uniform deposition results in a well-defined interface between the deposited layer and adjacent layers, such as the electron transport or hole transport layers. High-quality interfaces are critical for efficient charge separation and extraction, leading to better overall solar cell performance. The combination of the spraying rate, carrier gas flow, and director gas flow allows for efficient use of the precursor solution. This helps ensure minimal wastage while maximizing coverage and material deposition efficiency, making the process more cost-effective for large-scale or continuous production.

The directed spray ensures that the material is deposited evenly over the substrate, leading to improved film morphology. This is especially important in semitransparent thin film solar cells with customizable semitransparency, where maintaining uniformity in thickness and optical properties is crucial for transparency and light absorption. An optimized film morphology reduces optical losses and ensures better light management within the solar cell.

Spraying for 30 to 90 minutes at these controlled rates supports controlling the film thickness. The ability to control the film's uniformity, thickness, and quality over extended periods of time ensures consistent results across larger substrates and making the process suitable for industrial applications.

### EXAMPLES

### Example 1. Fabrication of ZnO based Sb₂S₃ solar cells.

Sb₂S₃ solar cells were assembled as the following structure: glass/transparent conductive oxide/TiO₂/ZnO/Sb₂S₃/P3HT/Au. Initially, pre-cleaned fluorine-doped tin oxide (FTO, ~10 Ω sq⁻¹) covered glass substrates were heated to 340 °C, whereupon a thin layer of TiO₂, the first electron transport layer, ETL1, was applied by spraying 70 cycles of 1:1 titanium(IV)isoproxide: acetylacetone molar ratio precursor solution, dissolved in ethanol. The prepared TiO₂ films were then heated at 450 °C for 30 min in air.

For the second electron transport layer, ETL2, was deposited comprising a solution containing 1:2 molar ratio of ZnCl₂ and tu, with ZnCl₂ concentration set at 5·10⁻⁴M in 70 cycles of this precursor were sprayed at various surface temperatures (Ts) ranging from 350 °C to 500 °C in air.

Afterwards, to optimize the thickness of ZnO layer, a series of different spraying cycles were conducted with cycles varying from 20 to 270 cycles, all deposited at the determined optimized temperature of 450 °C. Next, Sb₂S₃ absorber layers were ultrasonically sprayed onto both FTO/TiO₂ and FTO/TiO₂/ZnO surface. A precise total of 40 cycles of 1:3 SbCl₃ and tu solution (60 mM SbCl₃) in methanol were sprayed at a surface temperature of 185 °C in air. The as obtained amorphous Sb₂S₃ films were rapidly heat annealed at 270 °C under nitrogen atmosphere for 6 min.

For the HTL, 85 µL of 1 wt% P3HT solution was spun coated at 3000 rpm for 20 see and then thermally activated at 150 °C under nitrogen for 5 min. Finally, superstrate Sb₂S₃ solar cells were coated by Au contact by thermal evaporation technique.

### Example 2. Electrical parameters of semitransparent thin film solar cell.

The electrical parameters semitransparent thin film solar cell with absorbance layer comprising Sb₂S₃ and with a double electron layer comprising ZnO layer and TiO₂ layer are summarized in Table 1. Photovoltaic performance parameters of the control and ZnO sprayed at different cycles, measured under 100 mW/cm² illumination power. Results show increased solar cell output characteristics such as increased Voc, Jsc, FF, PCE, wherein Voc represents the maximum voltage across a solar cell when no external load is connected, Jsc represents the maximum current that flows through a solar cell when the voltage across it is zero, FF (fill factor) shows the ratio of real to theoretical power from a photovoltaic cell and the power conversion efficiency (PCE) of a solar PV cell is expressed as the percentage ratio of electrical power produced to optical power impinging on the cell.

**Table 1.**

| Devices | V_{oc} (mV) | J_{sc} (mA/cm²) | FF (%) | PCE (%) |
|---|---|---|---|---|
| Without ZnO | 676 ± 11 (686) | 13.85 ± 0.46 (14.50) | 55.57 ± 4.00 (60) | 4.97± 0.32 (5.69) |
| ZnO-20 cycles | 606 ± 33 (671) | 12.63 ± 1.04 (14.10) | 46.44 ± 3.50 (53) | 3.53 ± 025 (3.99) |
| ZnO-70 cycles | 642 ± 11 (658) | 14.11 ± 0.39 (14.50) | 59.00 ±1.92 (61) | 5.36 ± 0.15 (5.67) |
| ZnO-120 cycles | 725 ± 7 (733) | 5.16 ± 0.36 (15.70) | 58.64 ±3.47 (62) | 6.43 ± 0.36 (6.89) |
| ZnO-150 cycles | 729 ± 5 (737) | 16.20 ± 0.82 (17.90) | 57.25 ±2.27 (59) | 6.76 ± 0.48 (7.56) |
| ZnO-170 cycles | 722 ± 11 (737) | 16.25 ± 1.11 (18.40) | 56.00 ± 1.30 (58) | 6.57 ± 0.30 (7.23) |
| ZnO-220 cycles | 724 ± 16 (747) | 14.90 ± 0.42 (15.40) | 55.00 ± 1.00 (57) | 5.92 ± 0.29 (6.32) |
| ZnO-270 cycles | 710 ± 10 (724) | 13.28 ± 0.53 (14.10) | 55.00 ±1.00 (53) | 4.97 ± 0.32 (5.36) |

### Example 3. Method for depositing the absorber layer.

Sb₂S₃ absorber was carried using ultrasonic spray pyrolysis (USP) deposition technique with a nebulization frequency of 1.7 MHz and a power of 200 W. Compressed air (carrier gas) carrying the precursor solution flowed at 3 L/min, while the solution (director gas) itself was delivered at a rate of 0.5 L/min. The deposition employed a circular vertical nozzle 13 mm in diameter positioned 100 mm above the substrate. The nozzle followed a cyclical path to ensure uniform coating across a 170 mm × 170 mm effective area (total area 289 cm²).

The Sb₂S₃ absorber was grown from antimony chloride (SbCl₃) and thiourea (SCN₂H₄, tu) precursors. The tu concentration series was deposited at a temperature of 185 °C for 40 min from a solution of SbCl₃:tu in molar ratios of 1:3, 1:6 and 1:9.

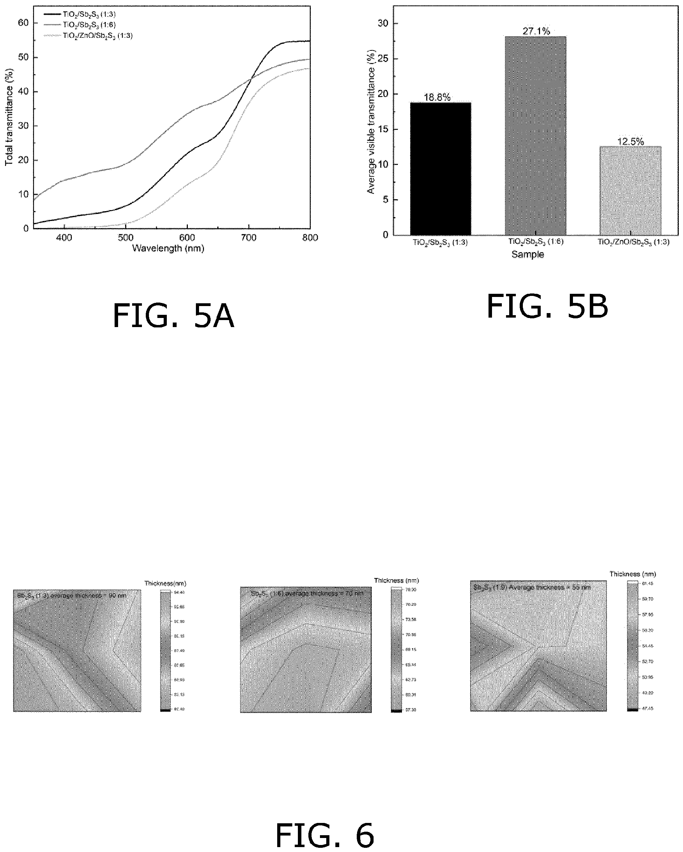

The concentrations of the SbCl₃:tu 1:3 precursors molar ratio were 60 mM SbCl₃ and 180 mM tu solutions respectively dissolved in methanol. All Sb₂S₃ absorbers were fabricated using 40 cycles of the USP. After the deposition of the Sb₂S₃, the samples were annealed on a hot plate at temperature of 270 °C in nitrogen environment for 6 min. In case of SbCl₃/tu molar ratio of 1:6 in the spray solution the optimal annealing time is 12 min. The results are presented in FIG. 6.

The fabrication of thin film solar cell with a Sb₂S₃ layer deposition form SbCl₃:tu solution with a molar ratio of 1:6 by USP results in a layer with optimal average thickness of ca. 70 nm. The optimal thickness of a Sb₂S₃ layer deposited form SbCl₃:tu solution with a molar ratio of 1:3 by USP is ca. 100 nm. The optimal thickness of a Sb₂S₃ layer deposited form SbCl₃:tu solution with a molar ratio of 1:3 onto double layer ETL by USP is ca. 150 nm.

### DETAILED DESCRIPTION OF THE DRAWINGS

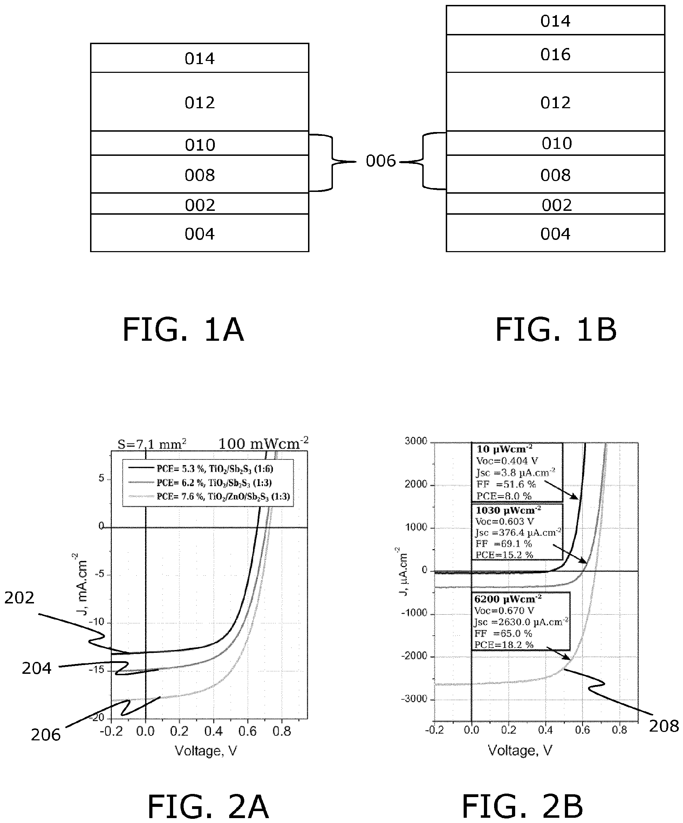

Referring to FIG. 1A and FIG. 1B, there is a schematic illustration of the semitransparent thin film solar cell with customizable semitransparency comprising following stacked layers, a substrate layer comprising a transparent conductive oxide **002,** TCO, on top of a glass layer **004,** a double electron transport layer **006,** ETL, comprising a first electron transport layer **008,** ETL1, and a second electron transport layer **010,** ETL2, deposited by ultrasonic spray pyrolysis, USP, an absorber layer **012** deposited by ultrasonic spray pyrolysis, USP and a back contact layer **014.** Referring to FIG. 1B optionally, the semitransparent thin film solar cell further comprises a hole transport layer **016,** HTL, between the absorber layer **012** and the back contact layer **014.**

It may be understood by a person skilled in the art that the FIG. 1A and FIG. 1B include a simplified architecture of the semitransparent thin film solar cell for sake of clarity, which should not unduly limit the scope of the claims herein. The person skilled in the art will recognize many variations, alternatives, and modifications of embodiments of the present disclosure.

FIG. 2A and FIG. 2B illustrate semitransparent thin film solar cell performance in 1.5AM standard test conditions (FIG. 2A) and low light conditions characteristic for indoors (FIG. 2B). A semi-transparent thin film solar cell with the following structure glass/TCO/TiO₂/Sb₂S₃/P3HT/Au was prepared by USP. FIG. 2A shows PCE progress of Sb₂S₃ solar cells Sb₂S₃(1:6) (**203**) and Sb₂S₃(1:3) (**204**) when the cleaned substrate layer, the double electron transport layer and the absorber layer are annealed at a temperature of 270 °C in nitrogen flow for 6 minutes (**204**) and 12 minutes (**203**). Furthermore, a breakthrough PCE=7.6% (206) is obtained for a semitransparent thin film solar cell comprising a double electron transport, ETL, (TiO₂/ZnO). For FIG. 2A conditions are standard conditions under 100 mWcm⁻² (1.5AM). FIG. 2B shows measurements under low illumination intensity showing the semitransparent thin film solar cells with I-PCE=18.2% (**208**) under 6200 µW/cm² (record I-PCE for semi-transparent USP absorber) (TiO₂/ZnO/Sb₂S₃ (1:3)).

FIG. 3A shows the evolution of XRD patterns of crystalline Sb₂S₃ absorber layers as the deposition temperature of ZnO increased from 350 °C to 500 °C. The detected diffraction peaks can be assigned to the pure orthorhombic stibnite with Pnma 62 space group (JCPDS 01-075-4012) (32). These peaks notably corresponding to (200), (102), (202), (011), (111), (302), (211), (212), and (402) planes. The texture coefficient of (011), (111) and (211) peaks arise above 1.0 independent of ZnO deposition temperature. This clearly support that the introduction of ZnO layer significantly promoted the growth and alignment of Sb₂S₃ crystallites towards (hkl) direction.

FIG. 3B illustrates texture coefficient of dominate diffraction peaks of the Sb₂S₃ films on single electron transport layer where ETL1 us TiO₂ and double electron transport layer where the first electron transport layer, ETL1, is TiO₂ and the second electron transport layer, ETL2, is ZnO. ZnO interface layer is deposited at different temperatures. This figure confirms that incorporation of the second electron transport layer resulted in better vertical alignment of Sb₂S₃ grains, including crystallite orientation in (hk1) direction.

FIG. 4 illustrates a cross-section SEM image of the semitransparent thin-layer solar cell with a substrate layer comprising a transparent conductive oxide **402,** TCO, on top of a glass substrate **404,** a double electron transport layer **406** comprising TiO₂ and ZnO and an absorber layer **408** of Sb₂S₃ deposited by ultrasonic spray pyrolysis.

FIG. 5A and FIG. 5B present a total transmittance spectra and average visible transmittance of the semitransparent thin-layer solar cell, respectively. In FIG. 5A, a total transmittance spectra of semitransparent thin film solar cell with a layer structure of glass/FTO/TiO₂/ZnO/Sb₂S₃(1:3), glass/FTO/TiO₂/Sb₂S₃(1:3) and glass/FTO/TiO₂/Sb₂S₃(1:6) is shown. In FIG. 5B average visible transmittance (AVT) of semitransparent thin film solar cell with a layer structure of glass/FrO/TiO₂/ZnO/Sb₂S₃(1:3), glass/FTO/TiO₂/Sb₂S₃(1:3) and glass/FTO/TiO₂/Sb₂S₃(1:6) is shown.

FIG. 6 illustrates XRF analysis results for thicknesses of the absorbance layer made of Sb₂S₃ thin films deposited from SbCl₃:tu molar ratio 1:3 (average thickness ca. 90 nm), 1:6 (average thickness ca. 70 nm) and 1:9 (average thickness ca. 55 nm) in the spray solution showing the impact of the Sb:S ratio.

FIG. 7 illustrates output parameters of the semitransparent thin layer solar cell depending on the ZnO layer thickness controlled via spray cycles for ZnO. Data is illustrated as statistical box plots of the Sb₂S₃ solar cell with the following layer structure FTO/TiO₂/ZnO/Sb₂S₃/P3HT/Au. A statistical analysis was conducted on the device parameters, including PCE, Voc, Jsc, and FF, wherein Voc represents the maximum voltage across a solar cell when no external load is connected, Jsc represents the maximum current that flows through a solar cell when the voltage across it is zero, FF (fill factor) shows the ratio of real to theoretical power from a photovoltaic cell and Rsh shows how much a solar cell's unwanted paths resist current flow and power conversion efficiency (PCE) of a solar PV cell is expressed as the percentage ratio of electrical power produced to optical power impinging on the cell..

FIG. 8 illustrates current density voltage (J-V) curves of the semitransparent thin film solar cell with the following layer structure (FTO/TiO₂/ZnO/Sb₂S₃/P3HT/Au) with ZnO interface layer deposited at 450 °C from various spraying cycles under illumination 100 mW/cm².

## Claims

1. A semitransparent thin film solar cell comprising following stacked layers:
- a substrate layer comprising a transparent conductive oxide (002), TCO, on top of a glass layer (004);
- a double electron transport layer (006), ETL, comprising
- a first electron transport layer (008), ETL1, and
- a second electron transport layer (010), ETL2, deposited by ultrasonic spray pyrolysis, USP;
- an absorber layer (012) deposited by ultrasonic spray pyrolysis, USP;
- a back contact layer (014).

2. A semitransparent thin film solar cell according to claim 1, further comprising a hole transport layer (016), HTL, between the absorber layer and the back contact layer.

3. A semitransparent thin film solar cell according to claim 2, wherein the absorber layer (012) thickness is from 40 nm up to 200 nm.

4. A semitransparent thin film solar cell according to any of the preceding claims, wherein at least one of the first electron transport layer (008), ETL1, and the second electron transport layer (010), ETL2, comprises at least one of selected materials from: TiO₂, ZnO, SnO₂, ZrO₂, ZnS, Zn(O,S), Sb-doped ZnO.

5. A semitransparent thin film solar cell according to any of the preceding claims, wherein the absorber layer (012) comprises at least one of selected materials from: Sb₂S₃, AgBiS₂, CuSbS₂, CuBiS₂, AgSbS₂, Bi₂S₃, Sb₂(S,Se)₃, Sb₂Se₃.

6. A semitransparent thin film solar cell according to any of the preceding claims, wherein the hole transport layer (016), HTL, comprises at least one of selected from: P3HT, NiOx, Spiro-OmeTAD, MnS, MoOs, small organic molecules.

7. A semitransparent thin film solar cell according to any of the preceding claims, wherein the back contact layer (014) comprises at least one of selected from: Au, Ag, Ag nanowires, C.

8. A method of preparing semitransparent thin film solar cell, the method comprising:
- cutting a glass substrate comprising a transparent conductive oxide layer (002), TCO, on top of a glass;
- cleaning the substrate layer;
- producing a double electron transport layer (006), ETL, on top of the substrate TCO layer by
- depositing a first electron transport layer (008), ETL1, and
- depositing a second electron transport layer (010), ETL2, by ultrasonic spray pyrolysis, USP;
- depositing an absorber layer (012) by ultrasonic spray pyrolysis, USP;
- annealing the cleaned substrate layer, the double electron transport layer (006) and the absorber layer (012) at a temperature range from 260 °C up to 310 °C in nitrogen flow for at least 2 minutes up to 20 minutes;
- adding a back contact layer (014).

9. A method according to claim 8, wherein depositing the absorber layer (012) by ultrasonic spray pyrolysis, USP, is carried out with following conditions:
- at a temperature range from 170 °C up to 210 °C for at least 20 minutes up to 120 minutes,
- depositing a precursor solution at a rate ranging from 2.0 ml/min up to 4.8 ml/min with a carrier gas at a rate ranging from 2 L/min up to of 5 L/min and a director gas from 0.2 L/min to 1 L/min form Sb₂S₃, wherein the precursor solution comprises an antimony chloride (SbCl₃) and a thiourea (SCN₂H₄, tu) with a molar ratio ranging from 1:2.5 up to 1:9 dissolved in methanol, and wherein the antimony chloride concentration is ranging from 15 mM up to 65 mM.

10. A method according to claims 7 or 8, wherein
- depositing the first electron transport layer (008), ETL1, comprises depositing titanium(IV)isoproxide and acetylacetone on the transparent conductive glass layer to form the first electron transport layer, wherein a molar ratio of titanium(IV)isoproxide and acetylacetone is ranging from 1:1 to 1:4 and temperature used during ultrasonic spray pyrolysis is ranging from 300 °C up to 500 °C;
- annealing the first electron transport layer (008) at temperature range from 400 °C up to 500 °C for at least 30 minutes up to 120 minutes, and
- depositing the second electron transport layer (010), ETL2, comprises spraying a solution onto the first electron transport layer (008) at temperature of 400 °C up to 500 °C to form a second electron transparent layer, wherein the solution comprises Zn(CH₃CO₂)₂ in deionized water and isopropyl alcohol mixture (2:3 by volume) with a Zn(CH₃CO₂)₂ concentration range from 1·10⁻⁴ mol/l up to 9·10⁻⁴ mol/l.

11. A method according to any of the claims 8-10, further comprising producing a hole transport layer (016), HTL, between the absorber layer (012) and the back contact layer (014), wherein the hole transport layer (016) is produced as, spiro-OMETAD, Poly(3-hexylthiophene-2,5-diyl), P3HT, MoOx layer, NiOx layer, MnS layer or NiOx nanoparticle layer.

12. A method according to claim 11, wherein producing the Poly(3-hexylthiophene-2,5-diyl), P3HT, layer comprises following steps:
- spin coating a Poly(3-hexylthiophene-2,5-diyl), P3HT, onto the absorber layer at speed of 3000 rpm for 0.33 minutes to form thin film layers, wherein the Poly(3-hexylthiophene-2,5-diyl) is dissolved in chlorobenzene with concentration of 1 wt%,
- heating the formed thin film layers in an inert atmosphere at 150 °C for 5 min.

13. A method according to any of the claims 8-12, wherein adding the back contact layer (014) is carried out by depositing at least one of: Au, Ag; and wherein depositing is carried out using vacuum evaporation technique or Ag nanowire.

14. A method according to any of the claims from 8-13, wherein depositing the absorber layer (012) comprising Sb₂S₃ by ultrasonic spray pyrolysis, USP, is carried out:
- at a nebulization frequency of ranging from 1 MHz up to 2 MHz, and
- with a power of ranging from 30 W up to 300 W.

15. A method according to any of the claims from 8-14, wherein spraying is carried at least 30 minutes up to 90 minutes at spraying rate ranging from 2 ml/min up to 5 ml/min using a carrier gas with the carrier gas rate ranging from 3 L/min up to 10 L/min and a director gas with the director gas rate ranging from 0.2 L/min up to 1 L/min.
